# FASCICULE DE BREVET EUROPEEN

(11) **EP 3 945 605 B1**
(45) Date de publication et mention de la délivrance du brevet: **22.10.2025**
(21) Numéro de dépôt: 21186291.7
(22) Date de dépôt: 19.07.2021
(51) Int. Cl.: H10D 8/01, H10D 8/00, H10D 62/85, H10D 64/00, H10D 64/62

(54) **DIODE SEMICONDUCTRICE ET PROCÉDÉ DE FABRICATION D'UNE TELLE DIODE**
HALBLEITERDIODE UND HERSTELLUNGSVERFAHREN EINER SOLCHEN DIODE
SEMICONDUCTOR DIODE AND METHOD FOR MANUFACTURING SUCH A DIODE

(30) Priorité: 28.07.2020 FR 2007953
(43) Date de publication de la demande: 02.02.2022
(73) Titulaire: Commissariat à l'Energie Atomique et aux Energies Alternatives, 75015 Paris (FR)
(72) Inventeur: BUCKLEY, Julien, 38054 GRENOBLE CEDEX 9 (FR)
(74) Mandataire: Cabinet Beaumont

(56) Documents cités:
- JP-A- 2015 023 073
- US-A1- 2013 328 120
- US-A1- 2015 035 047
- US-B2- 9 634 128

## Description

### Domaine technique

La présente description concerne de façon générale le domaine des composants électroniques de puissance, et vise plus particulièrement une diode semiconductrice et un procédé de fabrication d'une telle diode.

### Technique antérieure

De nombreuses structures de diodes semiconductrices de puissance ont déjà été proposées.

Des exemples de telles structures sont notamment décrites dans les articles intitulés "A High Current Operation in a 1.6 kV GaN-based Trenched Junction Barrier Schottky (JBS) Diode" (R. Kajitani et al., International Conference on Solid State Devices and Materials, 2015, pp.1056-1057), "Vertical GaN Junction Barrier Schottky Diodes by Mg Implantation and Activation Annealing" (A. D. Koehler et al., 2016 IEEE 4th Workshop on Wide Bandgap Power Devices and Applications, pp. 344-346), "Design and Realization of GaN Trench Junction-Barrier-Schottky-Diodes" (W. Li et al., IEEE Transactions on Electron Devices, vol. 64, no. 4, pp. 1635-1641, April 2017) et "Vertical GaN Junction Barrier Schottky Rectifiers by Selective Ion Implantation" (Y. Zhang et al., IEEE Electron Device Letters, vol. 38, no. 8, pp. 1097-1100, Aug. 2017), ou encore dans les demandes de brevet US2015035047, US2013328120 et JP2015023073. En particulier, le document US2015035047 divulgue une diode semi-conductrice, comportant une première région semi-conductrice dopée d'un premier type de conductivité, une deuxième région semi-conductrice dopée d'un deuxième type de conductivité opposé au premier type de conductivité, disposée sur et en contact avec la face supérieure de la première région semi-conductrice, une première région conductrice disposée sur et en contact avec la face supérieure de la deuxième région semi-conductrice, plusieurs cavités s'étendant à travers la première région conductrice et à travers la deuxième région semi-conductrice, une région diélectrique revêtant les parois latérales et le fond des cavités, une troisième région conductrice revêtant la région diélectrique sur les parois latérale et au fond des cavités, la troisième région conductrice étant en outre électriquement en contact avec la première région conductrice.

Les structures connues présentent toutefois divers inconvénients qu'il serait souhaitable de pallier en tout ou partie.

### Résumé de l'invention

Ainsi, un mode de réalisation prévoit une diode semiconductrice, comportant :
- une première région semiconductrice dopée d'un premier type de conductivité ;
- une deuxième région semiconductrice dopée d'un deuxième type de conductivité opposé au premier type de conductivité, disposée sur et en contact avec la face supérieure de la première région semiconductrice ;
- une première région conductrice disposée sur et en contact avec la face supérieure de la deuxième région semiconductrice, la première région conductrice comportant une ouverture traversante en regard d'une portion de la deuxième région semiconductrice ;
- une deuxième région conductrice en un matériau différent de celui de la première région conductrice, revêtant la face supérieure de la deuxième région semiconductrice en regard de ladite ouverture ;
- une cavité s'étendant à travers la deuxième région conductrice et à travers la deuxième région semiconductrice en regard d'une partie de ladite ouverture ;
- une région diélectrique revêtant les parois latérales et le fond de la cavité ;
- une troisième région conductrice revêtant la région diélectrique sur les parois latérales et au fond de la cavité, la troisième région conductrice étant en outre électriquement en contact avec les première et deuxième régions conductrices.

Selon un mode de réalisation, la deuxième région conductrice est en contact, par sa face inférieure, avec la face supérieure de la deuxième région semiconductrice en regard de ladite ouverture.

Selon un mode de réalisation, une troisième région semiconductrice du premier type de conductivité fait interface entre la deuxième région conductrice et la deuxième région semiconductrice en regard de ladite ouverture.

Selon un mode de réalisation, la région diélectrique recouvre la face supérieure de la deuxième région conductrice en vis-à-vis de ladite ouverture.

Selon un mode de réalisation, la région diélectrique présente une épaisseur équivalente en oxyde de silicium inférieure à 5 nm sur les parois latérales de la cavité, ladite épaisseur équivalente étant égale à (ε_{SiO2}/ε_{diel}) *t_{diel}, où ε_{SiO2},ε_{diel} et tdiel désignent respectivement la constante diélectrique de l'oxyde de silicium, la constante diélectrique du matériau de la région diélectrique, et l'épaisseur de la région diélectrique.

Selon un mode de réalisation, la deuxième région conductrice présente un travail de sortie inférieur à celui de la première région conductrice.

Selon un mode de réalisation, la deuxième région conductrice présente un travail de sortie égal, à 10 % près, à l'affinité électronique du matériau de la deuxième région semiconductrice.

Selon un mode de réalisation, la troisième région conductrice présente un travail de sortie inférieur ou égal à 5 eV.

Selon un mode de réalisation, chacune des première et deuxième régions semiconductrices comprend du nitrure de gallium.

Selon un mode de réalisation, la première région conductrice comprend du platine, du palladium, un alliage nickel-or, un alliage palladium-or, ou un alliage palladium-nickel-or.

Selon un mode de réalisation, la deuxième région conductrice comprend du titane, de l'aluminium, ou un alliage titane-aluminium.

Selon un mode de réalisation, la troisième région conductrice est en nitrure de titane.

Selon un mode de réalisation, la diode comporte en outre une quatrième région conductrice en contact avec la face inférieure de la première région semiconductrice.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe illustrant un exemple d'une structure de diode semiconductrice selon un mode de réalisation ;
la figure 2 est un diagramme illustrant la caractéristique courant-tension d'une diode du type décrit en relation avec la figure 1 ;
les figures 3A à 3H sont des vues en coupe illustrant des étapes successives d'un exemple d'un procédé de fabrication d'une diode semiconductrice selon un mode de réalisation ;
les figures 4A à 4F sont des vues en coupe illustrant des étapes successives d'un autre exemple d'un procédé de fabrication d'une diode semiconductrice selon un mode de réalisation ;
les figures 5A à 5C sont des vues en coupe illustrant des étapes successives d'un autre exemple d'un procédé de fabrication d'une diode semiconductrice selon un mode de réalisation ; et
les figures 6A à 6H sont des vues en coupe illustrant des étapes successives d'un autre exemple d'un procédé de fabrication d'une diode semiconductrice selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les utilisations que peuvent avoir les diodes décrites n'ont pas été détaillées, les modes de réalisation décrits étant compatibles avec toutes ou la plupart des utilisations connues de diodes semiconductrices de puissance.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

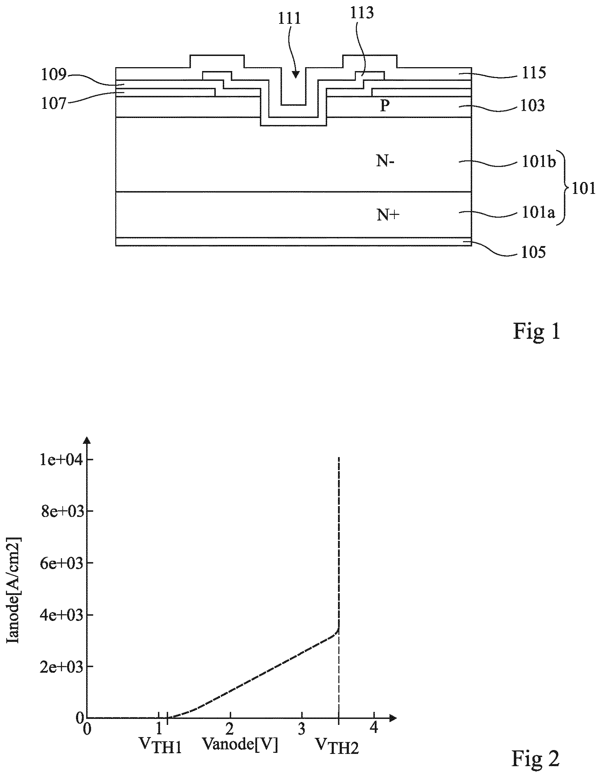

La figure 1 est une vue en coupe illustrant un exemple d'une structure de diode semiconductrice selon un mode de réalisation.

La diode de la figure 1 comprend une première région semiconductrice 101 dopée de type N, et, sur et en contact avec la face supérieure de la région 101, une deuxième région semiconductrice 103 dopée de type P. Les régions 101 et 103 forment respectivement une région semiconductrice de cathode et une région semiconductrice d'anode de la diode.

Dans l'exemple représenté, la région 101 comprend une région inférieure 101a relativement fortement dopée de type N, et, sur et en contact avec la face supérieure de la région 101a, une région supérieure 101b relativement faiblement dopée de type N. Dans cet exemple, la région 103 est en contact, par sa face inférieure, avec la face supérieure de la région 101b.

Chacune des régions 101a, 101b et 103 peut être en nitrure de gallium (GaN), ou en un alliage à base de nitrure de gallium. Le niveau de dopage de type N de la région 101b est par exemple compris entre 10¹⁵ et 10¹⁷ atomes/cm³. Le niveau de dopage de type N de la région 101a est par exemple compris entre 10¹⁸ et 10²⁰ atomes/cm³. Le niveau de dopage de type P de la région 103 est par exemple compris entre 5*10¹⁷ et 5*10²⁰ atomes/cm³. L'épaisseur de la région 101b est par exemple comprise entre 1 et 5 µm. L'épaisseur de la région 101a est par exemple comprise entre 200 µm et 400 µm. L'épaisseur de la région 103 est par exemple comprise entre 0,2 µm et 2 µm.

La diode de la figure 1 comprend en outre, du côté de sa face inférieure, une région conductrice 105, par exemple en métal, en contact, par sa face supérieure, avec la face inférieure de la région semiconductrice 101. La région conductrice 105 forme une électrode de cathode de la diode. Dans cet exemple, la région conductrice 105 est en contact, par sa face supérieure, avec la face inférieure de la région 101a. La région conductrice 105 forme un contact ohmique avec la face inférieure de la région semiconductrice 101a. La région conductrice 105 est par exemple en titane, en aluminium, en or, en nickel ou en un alliage d'un ou plusieurs de ces matériaux.

La diode de la figure 1 comprend de plus, du côté de sa face supérieure, une région conductrice 107, par exemple en métal, en contact, par sa face inférieure, avec la face supérieure de la région semiconductrice 103. La région conductrice 107 forme un contact ohmique, pour les trous, avec la face supérieure de la région semiconductrice 103. A titre d'exemple, la région 107 peut être en platine, en palladium, en un alliage nickel-or, en un alliage palladium-or, ou en un alliage palladium-nickel-or. L'épaisseur de la région conductrice 107 est par exemple comprise entre 100 nm et 1,5 µm.

La région conductrice 107 comporte une ouverture traversante en vis-à-vis d'une portion de la région semiconductrice 103, par exemple en vis-à-vis d'une portion centrale (en vue de dessus) de la région 103. Autrement dit, une portion de la région semiconductrice 103 n'est pas recouverte par la région conductrice 107.

La diode de la figure 1 comprend par ailleurs une région conductrice 109 en un matériau différent de celui de la région 107, revêtant la face supérieure de la région semiconductrice 103 en regard de la zone d'interruption de la région 107. Dans l'exemple de la figure 1, la région conductrice 109 est en contact, par sa face inférieure, avec la face supérieure de la région semiconductrice 103 en vis-à-vis de la zone d'interruption de la région conductrice 107. De plus, dans cet exemple, la région conductrice 109 s'étend sur et en contact avec la face supérieure de la région conductrice 107 en dehors de la zone d'interruption de la région conductrice 107. Le matériau de la région conductrice 109 présente de préférence un travail de sortie inférieur à celui du matériau de la région conductrice 107. A titre d'exemple, le matériau de la région 109 présente un travail de sortie sensiblement égal à l'affinité électronique du matériau semiconducteur de la région 103, par exemple de l'ordre de 4 eV pour le nitrure de gallium. A titre d'exemple, la région 109 peut être en titane, en aluminium, ou en un alliage titane-aluminium. L'épaisseur de la région conductrice 109 est par exemple comprise entre 40 nm et 150 nm.

La diode de la figure 1 comprend en outre, du côté de sa face supérieure, en vis-à-vis d'une partie de la zone d'interruption de la région conductrice 107, par exemple en vis-à-vis d'une partie centrale de l'ouverture formée dans la région conductrice 107, une tranchée ou cavité 111 s'étendant verticalement à travers la région conductrice 109 et la région semiconductrice 103, et débouchant dans ou sur la face supérieure de la région semiconductrice 101b.

La diode comprend de plus une région diélectrique 113, par exemple en oxyde de silicium (SiO₂), en nitrure de silicium (SiN), en oxyde d'hafnium (HfO₂), en alumine (Al₂O₃), ou en tout autre matériau diélectrique adapté, revêtant les parois latérales et le fond de la cavité 111. La région diélectrique 113 est notamment en contact avec les flancs des régions 103 et 109 au niveau des parois latérales de la cavité 111, et avec la région 101b au niveau du fond de la cavité 111. Dans l'exemple représenté, la région diélectrique 113 s'étend en outre sur et en contact avec la face supérieure de la région conductrice 109 en dehors de la cavité 111. Plus particulièrement, dans cet exemple, la région diélectrique 113 s'étend sur et en contact avec la face supérieure de la région conductrice 109 en vis-à-vis de l'ouverture formée dans la région conductrice 107, et en vis-à-vis d'une partie de l'empilement formé par les régions conductrices 107 et 109 à la périphérie de ladite ouverture. Une partie de l'empilement formé par les régions conductrices 107 et 109 n'est en revanche pas recouverte par la région diélectrique 113.

La diode de la figure 1 comprend en outre, du côté de sa face supérieure, une région conductrice 115 s'étendant sur et en contact avec la région diélectrique 113 sur les parois latérales et au fond de la cavité 111. La région conductrice s'étend en outre sur et en contact avec la face supérieure de la structure à l'extérieur de la cavité 111. Plus particulièrement, la région conductrice 115 s'étend sur et en contact avec la face supérieure de la région conductrice 109 en regard d'une portion de la région 109 non recouverte par la région diélectrique 113. La région conductrice supérieure 115 forme une électrode d'anode de la diode. La région conductrice 115 est par exemple en nitrure de titane.

La figure 2 est un diagramme illustrant la caractéristique courant-tension d'une diode du type décrit en relation avec la figure 1. La figure 2 représente plus particulièrement l'évolution de la densité surfacique de courant Ianode (en A/cm², en ordonnée) dans la diode en fonction de la tension Vanode (en V, en abscisse) appliquée entre l'électrode d'anode 115 et l'électrode de cathode 105 de la diode.

En dessous d'un premier seuil de tension V_{TH1}, de l'ordre de 1 V dans l'exemple représenté, le courant circulant entre l'anode et la cathode de la diode est nul ou négligeable.

Lorsque la tension Vanode atteint le seuil V_{TH1}, un canal d'inversion vertical se forme au voisinage des flancs de la région semiconductrice de type P 103, au niveau des parois latérales de la cavité 111. L'empilement des régions diélectrique 113 et conductrice 115 forme en effet, sur les parois latérales de la cavité 111, une grille conductrice isolée verticale qui, polarisée au-delà de la tension V_{TH1}, induit une inversion de la région semiconductrice 103 au voisinage des parois latérales de la cavité. La région conductrice 115 polarise simultanément la grille verticale et la région conductrice 109. La région conductrice 109, en contact, par sa face inférieure, avec la face supérieure de la région semiconductrice 103, permet de collecter les électrons du canal d'inversion. Un courant circule alors entre l'anode et la cathode de la diode. Ce courant augmente de façon monotone, par exemple linéairement, avec la tension Vanode, jusqu'à un deuxième seuil de tension V_{TH2}, supérieur au seuil V_{TH1}.

Lorsque la tension Vanode atteint le seuil V_{TH2}, des trous sont injectés depuis la région de type P 103 vers la région de type N 101b, induisant une modulation de la conductivité de la région 101b. Plus particulièrement, les trous injectés ont pour effet d'attirer électrostatiquement des électrons de la cathode, augmentant la conductivité de la région 101b. Un fort courant se met alors à circuler entre l'anode et la cathode de la diode, via la jonction PN formée à l'interface entre les régions 103 et 101.

Ainsi, la diode de la figure 1 présente deux modes de conduction, un mode de conduction dit nominal, permettant une commutation rapide de l'état bloqué à l'état passant et adapté à conduire des courants relativement faibles, et un mode de conduction dit de surcharge, présentant un seuil de déclenchement plus élevé et adapté à conduire des courants relativement élevés. La structure de la figure 1 permet en outre de bénéficier de courants de fuite particulièrement faibles à l'état bloqué.

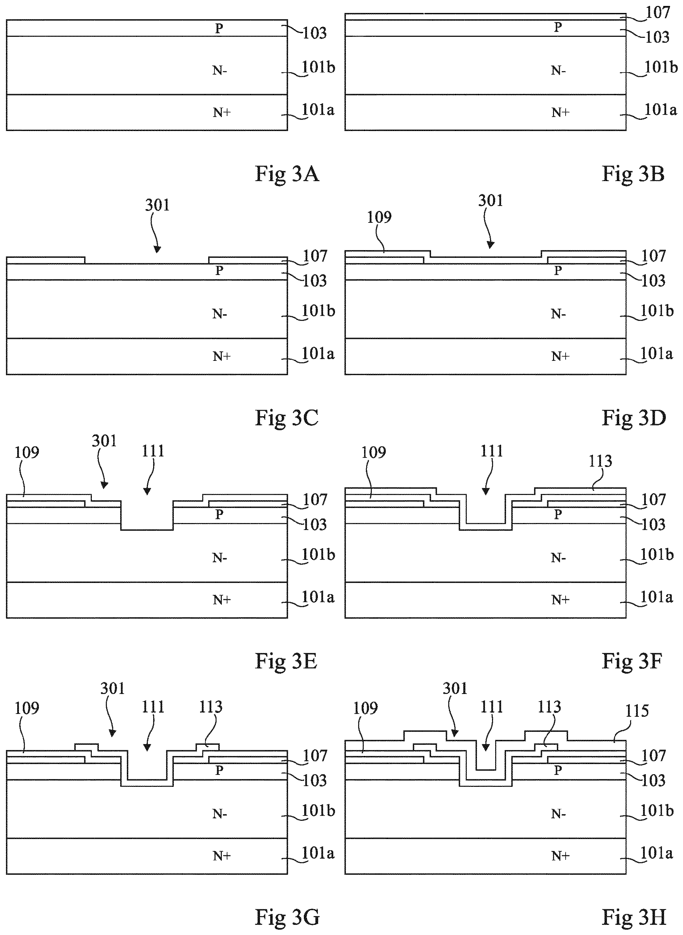

Les figures 3A à 3H sont des vues en coupe illustrant des étapes successives d'un exemple d'un procédé de fabrication d'une diode semiconductrice selon un mode de réalisation.

La figure 3A illustre une structure de départ comportant un empilement d'une couche semiconductrice 101a relativement fortement dopée de type N, correspondant à la région 101a de la diode de la figure 1, d'une couche semiconductrice 101b relativement faiblement dopée de type N, correspondant à la région 101b de la diode de la figure 1, et d'une couche semiconductrice 103 dopée de type P, correspondant à la région 103 de la diode de la figure 1. A titre d'exemple, la région 101b est formée par épitaxie sur et en contact avec la face supérieure de la région 101a, puis la région 103 est formée par épitaxie sur et en contact avec la face supérieure de la région 101b.

La figure 3B illustre la structure obtenue à l'issue d'une étape de dépôt d'une couche conductrice 107, correspondant à la région conductrice 107 de la diode de la figure 1, sur et en contact avec la face supérieure de la couche semiconductrice 103. A ce stade, la couche 107 s'étend de façon continue, par exemple sur une épaisseur sensiblement uniforme, sur toute la surface supérieure de la couche semiconductrice 103. De préférence, pour favoriser le contact électrique entre la couche semiconductrice 103 et la couche conductrice 107, la couche semiconductrice 103 comprend une portion superficielle (non détaillée sur les figures) fortement dopée de type P, par exemple de niveau de dopage supérieur ou égal à 10²⁰ atomes/cm³. A titre d'exemple, la portion superficielle fortement dopée peut être en nitrure de gallium et présenter une épaisseur de l'ordre de 10 nm. A titre de variante, la portion superficielle fortement dopée peut être en nitrure de gallium-indium, par exemple avec un taux d'indium compris dans la plage allant de 10% à 30%, et présenter une épaisseur comprise entre 2 et 10 nm.

La figure 3C illustre la structure obtenue à l'issue d'une étape de retrait localisé de la couche conductrice 107 et vis-à-vis d'une portion de la couche semiconductrice 103, de façon à former dans la couche 107 une ouverture traversante 301 débouchant sur la face supérieure de la couche semiconductrice 103. L'ouverture 301 est par exemple localisée en vis-à-vis d'une portion centrale (en vue de dessus) de la couche semiconductrice 103. A titre d'exemple, l'ouverture 301 est formée par photolithographie et gravure. Les dimensions latérales de l'ouverture 301 sont par exemple comprises entre 1 et 20 µm, par exemple entre 2 et 5 µm.

La figure 3D illustre la structure obtenue à l'issue d'une étape de dépôt d'une couche conductrice 109, correspondant à la région conductrice 109 de la diode de la figure 1, sur et en contact avec la face supérieure de la structure de la figure 3C. A ce stade, la couche 109 s'étend de façon continue, par exemple sur une épaisseur sensiblement uniforme, sur toute la surface supérieure de la structure, c'est-à-dire sur et en contact avec la face supérieure de la couche conductrice 107 en dehors de l'ouverture 301, sur et en contact avec les flancs de la couche conductrice 107 au niveau des parois latérales de l'ouverture 301, et sur et en contact avec la face supérieure de la couche semiconductrice 103 au fond de l'ouverture 301.

La figure 3E illustre la structure obtenue à l'issue d'une étape de gravure localisée des couches 109 et 103 en vis-à-vis de l'ouverture 301, pour former la cavité 111 de la diode de la figure 1. Les dimensions latérales de la cavité 111 sont inférieures à celles de l'ouverture 301. Dans l'exemple représenté, la cavité 111 est située en vis-à-vis d'une partie centrale de la cavité 301. A titre d'exemple, la distance, en vue de dessus, entre les parois latérales de l'ouverture 301 et les parois latérales de la cavité 111 est comprise entre 0,2 et 5 µm. Dans cet exemple, la cavité 111 débouche sur la face supérieure ou dans la couche semiconductrice 101b.

La figure 3F illustre la structure obtenue à l'issue d'une étape de dépôt d'une couche diélectrique 113 sur et en contact avec la face supérieure de la structure de la figure 3E. A ce stade, la couche 113 s'étend de façon continue, par exemple sur une épaisseur sensiblement uniforme, sur toute la surface supérieure de la structure, c'est-à-dire sur et en contact avec la face supérieure de la couche conductrice 109 en dehors de la cavité 111, sur et en contact avec les flancs des couches 109 et 103 au niveau des parois latérales de la cavité 111, et sur et en contact avec la face supérieure de la couche semiconductrice 101b au fond de la cavité 111.

La figure 3G illustre la structure obtenue à l'issue d'une étape de retrait localisé, par exemple par photolithographie et gravure, de la couche diélectrique 113, de façon à conserver uniquement une portion de la couche 113 correspondant à la région diélectrique 113 de la diode de la figure 1. Plus particulièrement, dans cet exemple, la couche 113 est conservée en regard de la cavité 111 et de l'ouverture 301, ainsi qu'au-dessus d'une partie de la région conductrice 107 à la périphérie de l'ouverture 301. La couche diélectrique 113 est en revanche entièrement retirée de façon à exposer la face supérieure de la couche conductrice 109 en vis-à-vis d'une portion périphérique de la structure. De préférence, l'épaisseur de la couche diélectrique 113 est relativement faible de façon à favoriser la formation d'un canal d'inversion vertical au niveau des flancs de la couche semiconductrice 103, et ainsi obtenir une caractéristique à deux seuils du type représenté en figure 2. A titre d'exemple, l'épaisseur équivalente en oxyde de silicium de la couche diélectrique 113 (égale à (ε_{SiO2}/ε_{diel}) *t_{diel}, où ε_{SiO2}, ε_{diel} et t_{diel} désignent respectivement la constante diélectrique de l'oxyde de silicium, la constante diélectrique du matériau de la couche 113, et l'épaisseur de la couche 113) est inférieure ou égale à 5 nm. De préférence, l'épaisseur physique de la couche 113 est supérieure ou égale à 1 nm pour limiter les courants de fuite à travers la couche 113.

La figure 3H illustre la structure obtenue à l'issue d'une étape de dépôt d'une couche conductrice 115, correspondant à l'électrode d'anode 115 de la diode de la figure 1, sur la face supérieure de la structure de la figure 3G. Dans cet exemple, la couche 115 s'étend de façon continue, par exemple sur une épaisseur sensiblement uniforme, sur toute la surface supérieure de la structure, c'est-à-dire sur et en contact avec la face supérieure de la couche conductrice 109 à la périphérie de la région diélectrique 113, et sur et en contact avec la face supérieure de la couche diélectrique 113 en partie centrale de la structure. De préférence, le travail de sortie du matériau de la couche 115 est relativement faible, par exemple inférieur ou égal à 5 eV, pour favoriser la formation d'un canal d'inversion vertical au niveau des flancs de la couche semiconductrice 103, et ainsi obtenir une caractéristique à deux seuils du type représenté en figure 2.

Une étape non représentée de dépôt de l'électrode de cathode 105 sur et en contact avec la face inférieure de la couche semiconductrice 101a peut en outre être prévue de façon à obtenir une structure du type décrit en relation avec la figure 1.

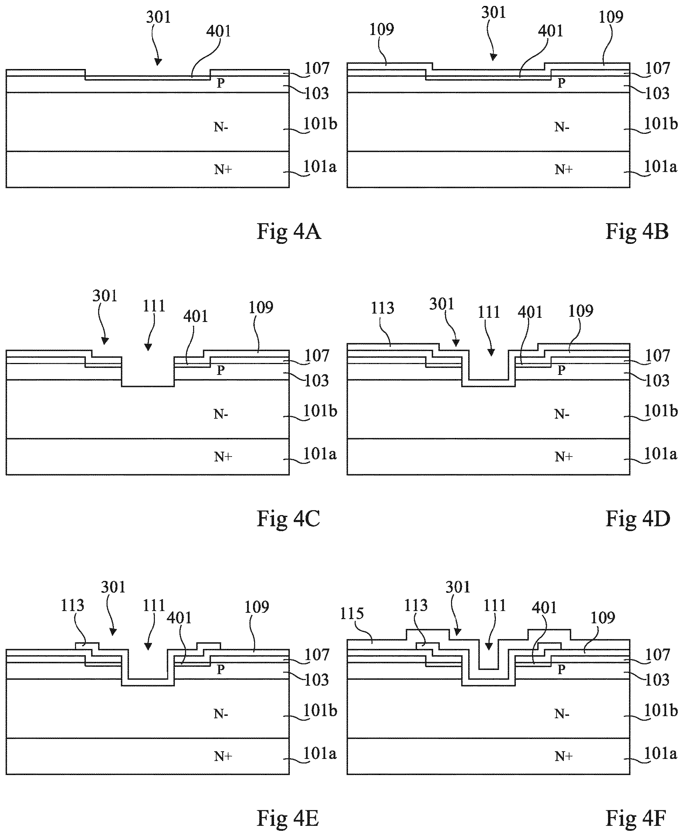

Les figures 4A à 4F sont des vues en coupe illustrant des étapes successives d'un autre exemple d'un procédé de fabrication d'une diode semiconductrice selon un mode de réalisation.

Les étapes initiales du procédé des figures 4A à 4F sont identiques ou similaires à ce qui été décrit en relation avec les figures 3A à 3C, et ne seront pas détaillées à nouveau ci-après.

La figure 4A illustre la structure obtenue à l'issue d'une étape d'implantation d'éléments dopants de type N, par exemple des atomes de silicium, dans une partie supérieure de la couche semiconductrice 103 en regard de l'ouverture 301. On obtient ainsi une région superficielle 401 dopée de type N en partie supérieure de la couche 103. Dans l'exemple représenté, la région 401 s'étend, en vue de dessus, sur toute la surface de l'ouverture 301. A titre d'exemple, la couche conductrice 107 sert de masque lors de l'étape d'implantation de façon à localiser la région 401 en vis à vis de l'ouverture 301 uniquement.

Les étapes suivantes, illustrées par les figures 4B à 4F, sont similaires à ce qui a été décrit ci-dessus en relation avec les figures 3D à 3H, à ceci près que, dans l'exemple des figures 4A à 4F, la couche conductrice 109 est en contact, par sa face inférieure, avec la face supérieure de la région 401 en vis-à-vis de l'ouverture 301.

La prévision de la région 401 permet d'améliorer la qualité du contact électrique entre la couche conductrice 109 et la couche semiconductrice 103.

L'épaisseur de la région implantée 401 est par exemple comprise entre 5 nm et 30 nm. Le niveau de dopage de la région implantée 401 est par exemple compris entre 10¹⁹ atomes/cm³ et 10²⁰ atomes/cm³.

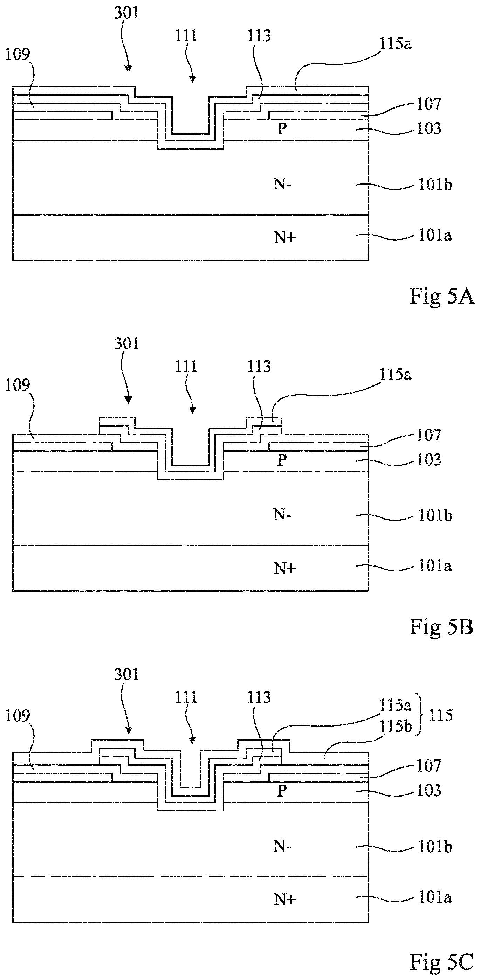

Les figures 5A à 5C sont des vues en coupe illustrant des étapes successives d'un autre exemple d'un procédé de fabrication d'une diode semiconductrice selon un mode de réalisation.

Les étapes initiales du procédé des figures 5A à 5C sont identiques ou similaires à ce qui été décrit en relation avec les figures 3A à 3F, et ne seront pas détaillées à nouveau ci-après.

Le procédé des figures 5A à 5C diffère du procédé des figures 3A à 3H en ce que, dans le procédé des figures 5A à 5C, une couche conductrice de grille 115a, par exemple de même nature que la couche 115 des exemples précédents, est déposée directement après l'étape de dépôt de la couche diélectrique 113, avant l'étape de gravure localisée de la couche 113, de façon à protéger la couche 113 lors de la gravure de grille.

La figure 5A illustre la structure obtenue à l'issue des étapes de dépôt des couches diélectrique 113 et conductrice 115a. A ce stade, chacune des couches 113 et 115a s'étend de façon continue, par exemple sur une épaisseur sensiblement uniforme, sur toute la surface supérieure de la structure.

La figure 5B illustre la structure obtenue à l'issue d'une étape de gravure simultanée (au moyen d'un même masque et selon un même motif) des couches 113 et 115a, visant à délimiter la grille conductrice isolée de la diode. Le motif de gravure correspond par exemple au motif de gravure de la couche diélectrique 113 à l'étape de la figure 3G.

La figure 5C illustre la structure obtenue à l'issue d'une étape de dépôt d'une couche conductrice supplémentaire 115b, par exemple de même nature que la couche 115a, sur la face supérieure de la structure de la figure 5B. Dans cet exemple, la couche 115b s'étend de façon continue, par exemple sur une épaisseur sensiblement uniforme, sur toute la surface supérieure de la structure, c'est-à-dire sur et en contact avec la face supérieure de la couche conductrice 109 autour de l'empilement de grille formé par les régions 113 et 115a, et sur et en contact avec la face supérieure de la couche conductrice 115a en partie centrale de la structure. Les régions 115a et 115b forment l'électrode d'anode 115 de la diode.

Comme dans les exemples précédents, une étape non représentée de dépôt de l'électrode de cathode 105 sur et en contact avec la face inférieure de la couche semiconductrice 101a peut en outre être prévue.

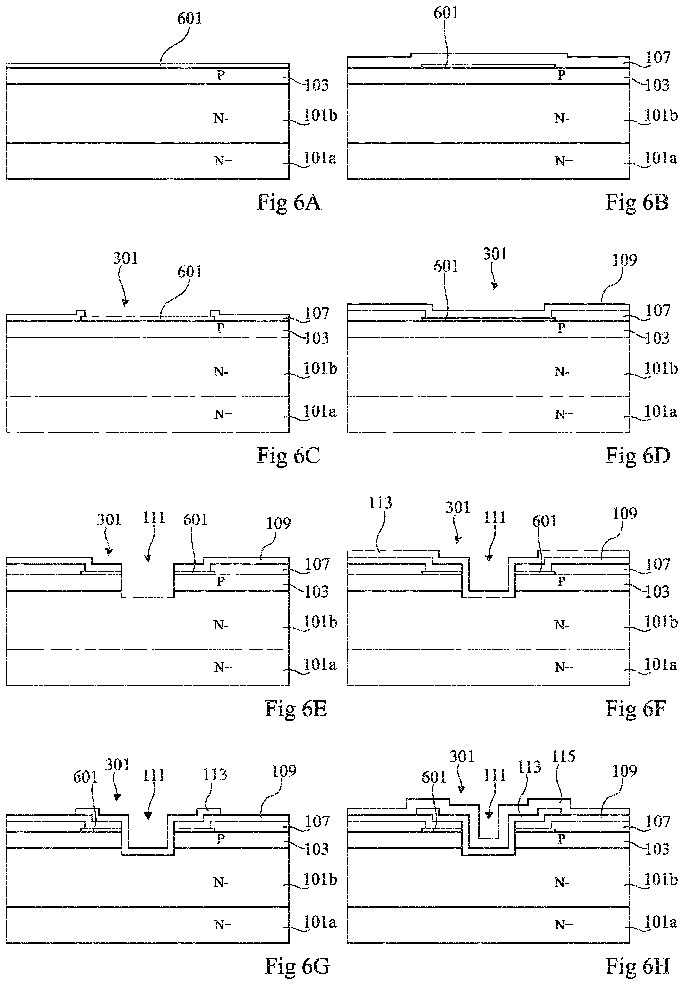

Les figures 6A à 6H sont des vues en coupe illustrant des étapes successives d'un autre exemple d'un procédé de fabrication d'une diode semiconductrice selon un mode de réalisation.

La figure 6A illustre la structure obtenue à l'issue d'une étape de formation d'une couche semiconductrice 601 dopée de type N sur et en contact avec la face supérieure d'une structure du type décrit en relation avec la figure 3A. La couche 601 est formée par épitaxie sur et en contact avec la face supérieure de la couche semiconductrice de type P 103. A ce stade, la couche 601 s'étend de façon continue et sur une épaisseur sensiblement uniforme sur toute la surface supérieure de la couche 103. L'épaisseur de la couche épitaxiée 601 est par exemple comprise entre 5 nm et 30 nm. Le niveau de dopage de la couche 601 est par exemple compris entre 10¹⁹ atomes/cm³ et 10²⁰ atomes/cm³.

Une étape de gravure localisé de la couche 601 est ensuite mise en oeuvre de façon à retirer la couche 601 et exposer la face supérieure de la couche 103 en périphérie de la structure, et conserver la couche 601 en regard d'une partie centrale de la structure.

Les étapes suivantes, illustrées par les figures 6B à 6H, sont similaires à ce qui a été décrit ci-dessus en relation avec les figures 3B à 3H. Dans l'exemple des figures 6A à 6H, l'ouverture 301 formée dans la couche conductrice 107 est localisée en vis-à-vis de la couche 601. Ainsi, la couche conductrice 109 est en contact, par sa face inférieure, avec la face supérieure de la couche 601 en vis-à-vis de l'ouverture 301.

La prévision de la couche 601 permet, de façon similaire à ce qui a été décrit en relation avec les figures4A à 4F, d'améliorer la qualité du contact électrique entre la couche conductrice 109 et la couche semiconductrice 103.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la variante des figures 5A à 5C peut être combinée avec la variante des figures 4A à 4F ou avec la variante des figures6A à 6H.

En outre, les modes de réalisation décrits ne se limitent pas aux exemples de matériaux et/ou de dimensions mentionnés dans la présente description.

De plus, bien que l'on ait représenté sur les figures des exemples de diodes comportant une unique structure de grille verticale isolée en vis-à-vis d'une partie centrale de la diode, en pratique, une diode selon un mode de réalisation peut comporter une pluralité de structures de grille verticale isolée identique ou similaires, réparties sur la surface de la diode.

## Revendications

1. Diode semiconductrice, comportant :
- une première région semiconductrice (101) dopée d'un premier type de conductivité ;
- une deuxième région semiconductrice (103) dopée d'un deuxième type de conductivité opposé au premier type de conductivité, disposée sur et en contact avec la face supérieure de la première région semiconductrice ;
- une première région conductrice (107) disposée sur et en contact avec la face supérieure de la deuxième région semiconductrice (103), la première région conductrice (107) comportant une ouverture traversante (301) en regard d'une portion de la deuxième région semiconductrice (103) ;
- une deuxième région conductrice (109) en un matériau différent de celui de la première région conductrice (107), revêtant la face supérieure de la deuxième région semiconductrice (103) en regard de ladite ouverture (301) ;
- une cavité (111) s'étendant à travers la deuxième région conductrice (109) et à travers la deuxième région semiconductrice (103) en regard d'une partie de ladite ouverture ;
- une région diélectrique (113) revêtant les parois latérales et le fond de la cavité (111) ;
- une troisième région conductrice (115) revêtant la région diélectrique (113) sur les parois latérales et au fond de la cavité (111), la troisième région conductrice (115) étant en outre électriquement en contact avec les première (107) et deuxième (109) régions conductrices.

2. Diode selon la revendication 1, dans laquelle la deuxième région conductrice (109) est en contact, par sa face inférieure, avec la face supérieure de la deuxième région semiconductrice (103) en regard de ladite ouverture (301).

3. Diode selon la revendication 1, dans laquelle une troisième région semiconductrice (401, 601) du premier type de conductivité fait interface entre la deuxième région conductrice (109) et la deuxième région semiconductrice (103) en regard de ladite ouverture (301).

4. Diode selon l'une quelconque des revendications 1 à 3, dans laquelle la région diélectrique (113) recouvre la face supérieure de la deuxième région conductrice (109) en vis-à-vis de ladite ouverture (301).

5. Diode selon l'une quelconque des revendications 1 à 4, dans laquelle la région diélectrique (113) présente une épaisseur équivalente en oxyde de silicium inférieure à 5 nm sur les parois latérales de la cavité (111), ladite épaisseur équivalente étant égale à (ε_{SiO2}/ε_{diel}) *t_{diel}, où ε_{SiO2,} ε_{diel} et t_{diel} désignent respectivement la constante diélectrique de l'oxyde de silicium, la constante diélectrique du matériau de la région diélectrique (113), et l'épaisseur de la région diélectrique (113).

6. Diode selon l'une quelconque des revendications 1 à 5, dans laquelle la deuxième région conductrice (109) présente un travail de sortie inférieur à celui de la première région conductrice (107).

7. Diode selon l'une quelconque des revendications 1 à 6, dans laquelle la deuxième région conductrice (109) présente un travail de sortie égal, à 10 % près, à l'affinité électronique du matériau de la deuxième région semiconductrice (103).

8. Diode selon l'une quelconque des revendications 1 à 7, dans laquelle la troisième région conductrice (115) présente un travail de sortie inférieur ou égal à 5 eV.

9. Diode selon l'une quelconque des revendications 1 à 8, dans laquelle chacune des première (101) et deuxième (103) régions semiconductrices comprend du nitrure de gallium.

10. Diode selon l'une quelconque des revendications 1 à 9, dans laquelle la première région conductrice (107) comprend du platine, du palladium, un alliage nickel-or, un alliage palladium-or, ou un alliage palladium-nickel-or.

11. Diode selon l'une quelconque des revendications 1 à 10, dans laquelle la deuxième région conductrice (109) comprend du titane, de l'aluminium, ou un alliage titane-aluminium.

12. Diode selon l'une quelconque des revendications 1 à 11, dans laquelle la troisième région conductrice (115) est en nitrure de titane.

13. Diode selon l'une quelconque des revendications 1 à 12, comportant en outre une quatrième région conductrice (105) en contact avec la face inférieure de la première région semiconductrice (101).

## Patentansprüche

1. Halbleiterdiode, aufweisend:
- einen ersten dotierten Halbleiterbereich (101) eines ersten Leitfähigkeitstyps;
- einen zweiten dotierten Halbleiterbereich (103) eines zweiten Leitfähigkeitstyps, der dem ersten Leitfähigkeitstyp entgegengesetzt ist und auf der Oberseite des ersten Halbleiterbereichs angeordnet ist und mit dieser in Kontakt steht;
- einen ersten leitfähigen Bereich (107), der auf der Oberseite des zweiten Halbleiterbereichs (103) angeordnet ist und mit dieser in Kontakt steht, wobei der erste leitfähige Bereich (107) eine Durchgangsöffnung (301) gegenüber einem Teil des zweiten Halbleiterbereichs (103) aufweist;
- einen zweiten leitfähigen Bereich (109) aus einem anderen Material als dem des ersten leitfähigen Bereichs (107), der die Oberseite des zweiten Halbleiterbereichs (103) gegenüber der Öffnung (301) bedeckt;
- einen Hohlraum (111), der sich durch den zweiten leitfähigen Bereich (109) und durch den zweiten Halbleiterbereich (103) gegenüber einem Teil der Öffnung erstreckt;
- einen dielektrischen Bereich (113), der die Seitenwände und den Boden des Hohlraums (111) bedeckt;
- einen dritten leitfähigen Bereich (115), der den dielektrischen Bereich (113) an den Seitenwänden und am Boden des Hohlraums (111) bedeckt, wobei der dritte leitfähige Bereich (115) außerdem in elektrischem Kontakt mit dem ersten (107) und dem zweiten (109) leitfähigen Bereich steht.

2. Diode nach Anspruch 1, wobei der zweite leitfähige Bereich (109) mit seiner Unterseite mit der Oberseite des zweiten Halbleiterbereichs (103) gegenüber der Öffnung (301) in Kontakt steht.

3. Diode nach Anspruch 1, wobei ein dritter Halbleiterbereich (401, 601) des ersten Leitfähigkeitstyps eine Grenzfläche zwischen dem zweiten leitfähigen Bereich (109) und dem zweiten Halbleiterbereich (103) gegenüber der Öffnung (301) bildet.

4. Diode nach einem der Ansprüche 1 bis 3, wobei der dielektrische Bereich (113) die Oberseite des zweiten leitfähigen Bereichs (109) gegenüber der Öffnung (301) bedeckt.

5. Diode nach einem der Ansprüche 1 bis 4, wobei der dielektrische Bereich (113) eine äquivalente Siliziumoxid-Dicke von weniger als 5 nm an den Seitenwänden des Hohlraums (111) aufweist, wobei die äquivalente Dicke gleich (ε_{SiO2}/ε_{diel})*t_{diel}, where ε_{SiO2}, ε_{diel} and t_{diel} die Dielektrizitätskonstante von Siliziumoxid, die Dielektrizitätskonstante des Materials des dielektrischen Bereichs (113) bzw. die Dicke des dielektrischen Bereichs (113) bezeichnen.

6. Diode nach einem der Ansprüche 1 bis 5, wobei der zweite leitfähige Bereich (109) eine Austrittsarbeit aufweist, die kleiner ist als die des ersten leitfähigen Bereichs (107).

7. Diode nach einem der Ansprüche 1 bis 6, wobei der zweite leitfähige Bereich (109) eine Austrittsarbeit aufweist, die innerhalb von 10 % der Elektronenaffinität des Materials des zweiten Halbleiterbereichs (103) entspricht.

8. Diode nach einem der Ansprüche 1 bis 7, wobei der dritte leitfähige Bereich (115) eine Austrittsarbeit von weniger als oder gleich 5 eV aufweist.

9. Diode nach einem der Ansprüche 1 bis 8, wobei sowohl der erste (101) als auch der zweite (103) Halbleiterbereich Galliumnitrid aufweist.

10. Diode nach einem der Ansprüche 1 bis 9, wobei der erste leitfähige Bereich (107) Platin, Palladium, eine Nickel-Gold-Legierung, eine Palladium-Gold-Legierung oder eine Palladium-Nickel-Gold-Legierung aufweist.

11. Diode nach einem der Ansprüche 1 bis 10, wobei der zweite leitfähige Bereich (109) Titan, Aluminium oder eine Titan-Aluminium-Legierung aufweist.

12. Diode nach einem der Ansprüche 1 bis 11, wobei der dritte leitfähige Bereich (115) aus Titannitrid besteht.

13. Diode nach einem der Ansprüche 1 bis 12, die ferner einen vierten leitfähigen Bereich (105) aufweist, der mit der Unterseite des ersten Halbleiterbereichs (101) in Kontakt steht.

## Claims

1. Semiconductor diode, comprising:
- a first doped semiconductor region (101) of a first conductivity type;
- a second doped semiconductor region (103) of a second conductivity type opposite to the first conductivity type, arranged on top of and in contact with the upper surface of the first semiconductor region;
- a first conductive region (107) arranged on top of and in contact with the upper surface of the second semiconductor region (103), the first conductive region (107) comprising a through opening (301) opposite a portion of the second semiconductor region (103);
- a second conductive region (109) made of a material different from that of the first conductive region (107), coating the upper surface of the second semiconductor region (103) opposite said opening (301);
- a cavity (111) extending through the second conductive region (109) and through the second semiconductor region (103) opposite a portion of said opening;
- a dielectric region (113) coating the lateral walls and the bottom of the cavity (111);
- a third conductive region (115) coating the dielectric region (113) on the lateral walls and at the bottom of the cavity (111), the third conductive region (115) being further electrically in contact with the first (107) and second (109) conductive regions.

2. Diode according to claim 1, wherein the second conductive region (109) is in contact, by its lower surface, with the upper surface of the second semiconductor region (103) opposite said opening (301).

3. Diode according to claim 1, wherein a third semiconductor region (401, 601) of the first conductivity type forms an interface between the second conductive region (109) and the second semiconductor region (103) opposite said opening (301).

4. Diode according to any of claims 1 to 3, wherein the dielectric region (113) covers the upper surface of the second conductive region (109) opposite said opening (301).

5. Diode according to any of claims 1 to 4, wherein the dielectric region (113) has an equivalent silicon oxide thickness smaller than 5 nm on the lateral walls of the cavity (111), said equivalent thickness being equal to (ε_{SiO2}/ε_{diel}) *t_{diel}, where ε_{SiO2}, ε_{diel} and t_{diel} respectively designates the dielectric constant of silicon oxide, the dielectric constant of the material of the dielectric region (113), and the thickness of the dielectric region (113).

6. Diode according to any of claims 1 to 5, wherein the second conductive region (109) has a work function smaller than that of the first conductive region (107).

7. Diode according to any of claims 1 to 6, wherein the second conductive region (109) has a work function equal, within 10%, to the electron affinity of the material of the second semiconductor region (103).

8. Diode according to any of claims 1 to 7, wherein the third conductive region (115) has a work function smaller than or equal to 5 eV.

9. Diode according to any of claims 1 to 8, wherein each of the first (101) and second (103) semiconductor regions comprises gallium nitride.

10. Diode according to any of claims 1 to 9, wherein the first conductive region (107) comprises platinum, palladium, a nickel-gold alloy, a palladium-gold alloy, or a palladium-nickel-gold alloy.

11. Diode according to any of claims 1 to 10, wherein the second conductive region (109) comprises titanium, aluminum, or a titanium-aluminum alloy.

12. Diode according to any of claims 1 to 11, wherein the third conductive region (115) is made of titanium nitride.

13. Diode according to any of claims 1 to 12, further comprising a fourth conductive region (105) in contact with the lower surface of the first semiconductor region (101).
